# EUROPEAN PATENT APPLICATION

(11) **EP 3 071 002 A1**
(43) Date of publication of application: **21.09.2016**
(21) Application number: 14876888.0
(22) Date of filing: 29.12.2014
(51) Int. Cl.: H05K 1/02

(54) **FLEXIBLE PRINTED CIRCUIT**

(30) Priority: 30.12.2013 CN 201320879733 U
(71) Applicant: Kunshan Visionox Display Co., Ltd., Kunshan, Jiangsu 215300 (CN)
(72) Inventor: AN, Leping, Kunshan City Jiangsu 215300 (CN); WANG, Long, Kunshan City Jiangsu 215300 (CN); GAO, Ming, Kunshan City Jiangsu 215300 (CN); HONG, Yao, Kunshan City Jiangsu 215300 (CN); PU, Bin, Kunshan City Jiangsu 215300 (CN)
(74) Representative: Walsh, Marie Goretti
(86) International application number: PCT/CN2014/095332
(87) International publication number: WO 2015/101256

(57) **Abstract**

The present invention discloses a flexible circuit board. The flexible circuit board comprises a base portion and a grounding soft board extending from the base portion, the grounding soft board comprising a board body connected to the base portion and a contact end provided at a free end of the board body, the contact end comprising a bonding region and a windowing copper exposure region arranged inside the bonding region, and the board body being in a curved shape. According to the present invention, by making improvements on the bonding area between the grounding soft board and the shielding layer and on the shape of the soft board, and by increasing the bonding power and dispersing the folding stress, the grounding soft board is prevented from falling off at portions contacting the shielding layer when folded or transported.

## Description

### TECHNICAL FIELD

The present invention relates to a flexible circuit board, and in particular to a grounding soft board which, on a flexible circuit, contacts a shielding layer of a touch screen board and is prevented from falling off.

### BACKGROUND

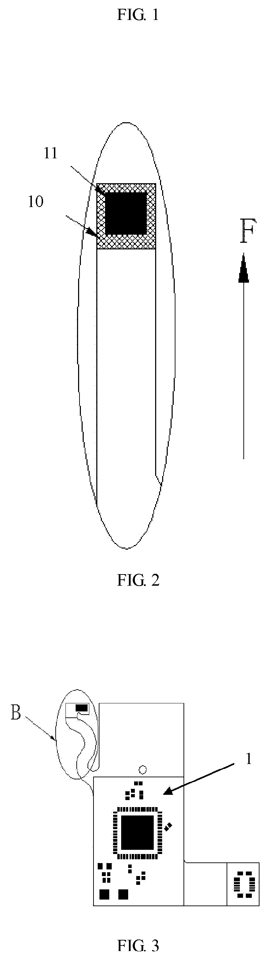

At present, in designs of shape, structure and circuit of a flexible printed circuit (FPC), a grounding soft board portion bonded with a shielding layer is generally strip-shaped (as shown by part A in FIG. 1). A windowing copper exposure region 11 is arranged inside a bonding region 10 at an end of the grounding soft board. As shown in FIG. 2, the bonding area between the grounding soft board and the shielding layer is an area between the bonding region 10 and the windowing copper exposure region 11. Since the bonding area therebetween is small, the stressed points are relatively concentrated. Since this grounding soft board is strip-shaped, when stressed by an external force F (the stressed direction is indicated by an arrow), there is only one stressed direction and the stressed direction is in the body direction of the grounding soft board. Thus, the grounding soft board contacting the shielding layer is likely to fall off when folded and transported.

### SUMMARY

### Technical problem

In view of this, a main objective of the present invention is to provide a flexible circuit board which can increase the bonding power.

### Technical solution

In order to achieve the objective mentioned above, the present invention provides a flexible circuit board. The flexible circuit board includes a base portion and a grounding soft board extending from the base portion. The grounding soft board includes a board body connected to the base portion and a contact end arranged at a free end of the board body. The contact end includes a bonding region and a windowing copper exposure region arranged inside the bonding region. The board body is in a curved shape.

The board body is S-shaped or W-shaped.

The grounding soft board is configured to be contacted with a shielding layer of a touch screen, and a bonding area between the bonding region and the shielding layer is more than twice the bonding area between the windowing copper exposure region and the shielding region.

The bonding region is L-shaped, T-shaped or cross-shaped.

An anisotropic conducting adhesive film is coated on the bonding region and the windowing copper exposure region.

### Beneficial effect

According to the present invention, by making improvements on the bonding area between the grounding soft board and the shielding layer and on the shape of the soft board, and by increasing the bonding power and dispersing the folding stress, the grounding soft board is prevented from falling off at portions contacting the shielding layer when folded or transported.

### BRIEF DESCRIPTION OF THE DRAWINGS

FIG. 1 is a schematic structural view of an existing grounding soft board, which is strip-shaped;
FIG. 2 is an enlarged view of part A in FIG. 1;
FIG. 3 is a schematic structural view of a grounding soft board according to the present invention;
FIG. 4 is an enlarged view of part B in FIG. 3; and
FIG. 5 is a view showing a stressed direction of the grounding soft board according to the present invention.

### DETAILED DESCRIPTION

For the purpose of further understanding the structure and effect of the present invention, the present invention will be described hereinafter in detail with reference to the accompanying drawings and preferred embodiments.

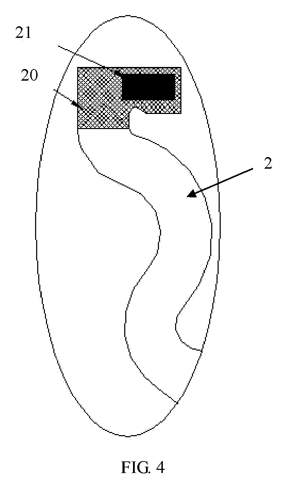

As shown in FIG. 3 and FIG. 4, the flexible circuit board of the present invention includes a base portion 1 and a grounding soft board B extending from the base portion 1. The grounding soft board B is configured to be contacted with a shielding layer of a touch screen. The grounding soft board B includes a board body 2 connected to the base portion 1 and a contact end arranged at a free end of the board body 2. The contact end includes a bonding region 20 and a windowing copper exposure region 21 arranged inside the bonding region 20. An anisotropic conducting adhesive film is coated on the bonding region 20 and the windowing copper exposure region 21. The bonding region 20 according to the present invention may be L-shaped. When compared with a square or rectangular bonding region, the bonding region 20 according to the present invention has a larger area. The area of the bonding between the grounding soft board B and the shielding layer may be increased such that the bonding area between the bonding region 20 and the shielding layer is more than twice the bonding area between the windowing copper exposure region 21 and the shielding layer. In this way, the bonding force of the grounding soft board B with the shielding layer is enhanced such that the grounding soft board B is prevented from falling off from the shielding layer when folded or transported. The bonding region 20 according to the present invention is not limited to an L-shape, and may also be in a T-shape, a cross-shape or other shapes which may increase the bonding area.

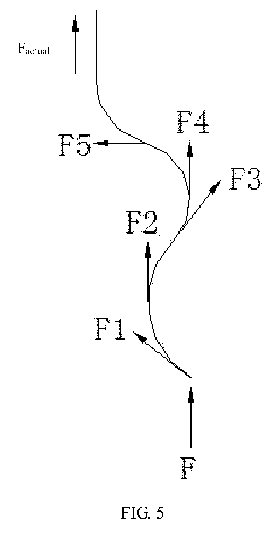

The board body 2 of the grounding soft board B of the present invention is in a curved shape. As shown in FIG. 3 and FIG. 4, the board body is S-shaped. When the grounding soft board is stressed by an actual external force Factual, this Factual is divided into folding stresses F1, F2, F3, F4 and F5 (as shown in FIG. 5) in various directions along the tangential direction of an edge of the board body 2, in order to weaken the force applied on a local portion of the board body 2. Thus, when the grounding soft board B of the present invention is stressed during folding or transportation, the bonding portion between the grounding soft board B and the shielding layer is less likely to fall off. The board body 2 of the grounding soft board B of the present invention is not limited to be an S-shape, and may be in a W-shape or other curved shapes.

According to the present invention, by making improvements on the bonding area between the grounding soft board and the shielding layer and on the shape of the soft board, and by increasing the bonding power and dispersing the folding stress, the grounding soft board is prevented from falling off at portions contacting the shielding layer when folded or transported.

Above described is merely a preferred embodiment of the present invention, and is not intended to limit the protection scope of the present invention.

## Claims

1. A flexible circuit board, comprising a base portion and a grounding soft board extending from the base portion, the grounding soft board comprising a board body connected to the base portion and a contact end arranged at a free end of the board body, the contact end comprising a bonding region and a windowing copper exposure region arranged inside the bonding region, and the board body being in a curved shape.

2. The flexible circuit board according to claim 1, wherein the board body is S-shaped or W-shaped.

3. The flexible circuit board according to claim 1, wherein the grounding soft board is configured to be contacted with a shielding layer of a touch screen, and a bonding area between the bonding region and the shielding layer is more than twice a bonding area between the windowing copper exposure region and the shielding region.

4. The flexible circuit board according to claim 3, wherein the bonding region is L-shaped, T-shaped or cross-shaped.

5. The flexible circuit board according to claim 1, wherein an anisotropic conducting adhesive film is coated on the bonding region and the windowing copper exposure region.
